(19) Europäisches Patentamt / European Patent Office / Office européen des brevets

(11) **EP 2 304 760 B1**

(12) **FASCICULE DE BREVET EUROPEEN**

(45) Date de publication et mention de la délivrance du brevet:
**25.06.2014 Bulletin 2014/26**

(21) Numéro de dépôt: **09769497.0**

(22) Date de dépôt: **28.05.2009**

(51) Int Cl.:
*H01H 83/20* (2006.01)     *G01R 22/06* (2006.01)

(86) Numéro de dépôt international:
**PCT/FR2009/051008**

(87) Numéro de publication internationale:
**WO 2009/156656 (30.12.2009 Gazette 2009/53)**

(54) **COMPTEUR ÉLECTRONIQUE AVEC UN ORGANE COUPURE, UN CIRCUIT DE COMMANDE À LA FERMETURE DE L'ORGANE COUPURE ET UN CIRCUIT GÉNÉRATEUR D'UN COURANT HF**

ELEKTRONISCHER ELEKTRIZITÄTSZÄHLER MIT EINER TRENNVORRICHTUNG, EINER STEUERSCHALTUNG ZUM SCHLIESSEN DER TRENNVORRICHTUNG UND EINER HOCHFREQUENZSTROMGENERATORSCHALTUNG

ELECTRONIC METER WITH A DISCONNECTING DEVICE, A CONTROL CIRCUIT FOR CLOSING THE DISCONNECTING DEVICE AND A HF CURRENT GENERATING CIRCUIT

(84) Etats contractants désignés:
**AT BE BG CH CY CZ DE DK EE ES FI FR GB GR HR HU IE IS IT LI LT LU LV MC MK MT NL NO PL PT RO SE SI SK TR**

(30) Priorité: **29.05.2008 FR 0853545**

(43) Date de publication de la demande:
**06.04.2011 Bulletin 2011/14**

(73) Titulaire: **Electricité de France**
**75008 Paris (FR)**

(72) Inventeurs:
• **PELLETIER, Aude**
  **F-92130 Issy Les Moulineaux (FR)**
• **MOULARD, Jean-Michel**
  **F-78860 Saint Nom La Breteche (FR)**

(74) Mandataire: **Cabinet Plasseraud**
**52, rue de la Victoire**
**75440 Paris Cedex 09 (FR)**

(56) Documents cités:
**EP-A- 0 084 634     ES-A2- 2 063 699**
**JP-A- 11 273 538**

## Description

L'invention concerne un compteur d'énergie électrique muni d'un dispositif de fermeture de l'organe de coupure de ce compteur par action sur un disjoncteur de branchement client, séparant le réseau de distribution du réseau domestique du client.

A l'heure actuelle, les clients résidentiels abonnés à la distribution d'électricité sont en général raccordés au réseau de distribution d'énergie électrique et disposent d'un disjoncteur de branchement et d'un compteur d'énergie électrique.

Le compteur est un élément de mesure et d'enregistrement de consommation d'énergie électrique. Il peut être installé à l'intérieur ou à l'extérieur de l'habitat, en limite de propriété ou dans un local commun d'un immeuble. Un compteur d'énergie électrique situé hors de l'habitat est dit « inaccessible » pour le client abonné ou pour l'ensemble de ces derniers occupant un immeuble. Cette situation représente en 2007 en France environ 50 % du parc des clients résidentiels.

Le disjoncteur de branchement est l'élément de protection et de sécurité, lequel est toujours situé dans l'habitat, de façon à être accessible directement aux clients abonnés. L'ouverture de ce disjoncteur est automatique pour protéger d'un défaut, par exemple en cas de court-circuit, mais également lors d'un dépassement de puissance consommée vis-à-vis de la puissance souscrite contractuellement et aussi pour mettre hors tension l'installation client.

Les gestionnaires de réseaux de distribution d'électricité visent à proposer des compteurs d'énergie électrique inaccessibles au client, dont l'objet est de fournir une solution simple et efficace permettant de refermer l'organe de coupure du compteur à distance, depuis l'installation domestique directement accessible aux clients abonnés dans l'habitat de ces derniers.

Le principe consistant à refermer l'organe de coupure du compteur par une action sur le disjoncteur de branchement de l'installation client a été décrit par la société de droit espagnol Circutor.

En particulier la société Circutor est titulaire d'une demande de brevet en Espagne ES 2063699 dont l'objet est de contrer une éventuelle fraude du client abonné sur son disjoncteur installé à l'intérieur de l'habitat.

Le disjoncteur intérieur situé dans l'habitat est accessible pour le client abonné et ce dernier peut donc en modifier frauduleusement le réglage, afin de disposer d'une puissance plus élevée que celle souscrite contractuellement.

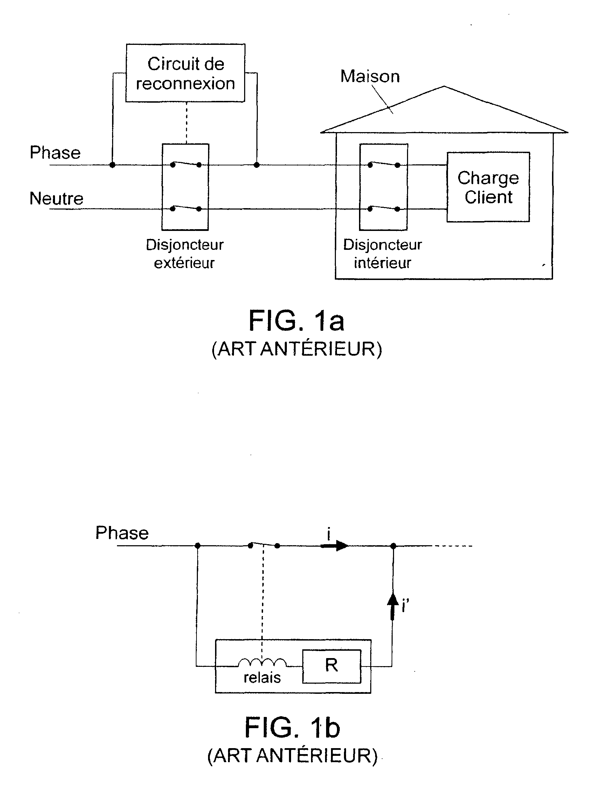

Pour parer à une telle tentative, la solution décrite dans le brevet Circutor consiste à installer un deuxième disjoncteur extérieur à l'habitat, inaccessible pour le client abonné, auquel vient s'ajouter un dispositif permettant d'exécuter la reconnexion distante, ainsi que représenté en figure 1a.

Le disjoncteur extérieur supplémentaire est strictement identique au disjoncteur intérieur et réglé à la même valeur de coupure correspondant à la puissance souscrite contractuellement. Dans l'hypothèse où le client abonné règle frauduleusement la puissance de son disjoncteur intérieur à une valeur supérieure à la puissance souscrite, c'est l'ouverture du disjoncteur extérieur qui assure la bonne limitation de puissance à la valeur contractuelle. Le circuit de reconnexion permet alors aux clients abonnés de refermer aisément le disjoncteur extérieur depuis son habitat en actionnant son disjoncteur intérieur.

Un tel mode opératoire est mis en oeuvre à partir d'un circuit de reconnexion installé dans le disjoncteur extérieur de type magnétothermique, identique à celui qui est situé dans l'habitat. Le circuit de reconnexion est constitué pour chaque phase et pour le neutre d'une résistance, d'un relais, et d'un moteur actionné par le relais tel que représenté en figure 1b, pour la phase par exemple.

Suite à l'ouverture du disjoncteur extérieur par l'abonné client, cette ouverture engendre un courant i', désigné courant de réseau abonné de refermeture, dont la valeur en monophasé est donnée par la relation (1) :

$$i' = \frac{U_{\,réseau}}{2R + Z_{\,habitat}}$$

dans la relation précédente U réseau désigne la tension du réseau et Z habitat désigne l'impédance équivalente de l'installation du logement considéré. La valeur i' de l'intensité du courant est donnée dans le cas où un circuit de reconnexion comprenant la résistance R est présent sur la phase et sur le neutre.

Dans cette situation, lorsque le client abonné ouvre le disjoncteur intérieur, l'intensité i' devient nulle et le passage à zéro de l'intensité précitée est détecté par le relais, lequel actionne le moteur. Ce dernier referme mécaniquement le disjoncteur extérieur. La fermeture du disjoncteur intérieur par le client abonné permet à ce dernier de remettre l'installation domestique sous tension.

Bien entendu un tel mode opératoire peut être mis en oeuvre dans un compteur d'énergie électrique. Une telle solution a été présentée au salon Metering Europe 2006 par la société Circutor. Dans cette situation l'organe de coupure ne coupe que la phase en créant un courant exprimé, selon la relation (2) de la forme :

$$i' = \frac{U_{\,réseau}}{R + Z_{\,habitat}}$$

Où $U_{\,réseau}$ est la tension du réseau et $Z_{\,réseau}$

est l'impédance équivalente du logement considéré.

La solution précitée permet la reconnexion de l'installation domestique de l'abonné client, dont le compteur est inaccessible. Dans ce but, le disjoncteur de branchement, toujours placé à l'intérieur de l'habitat, est donc accessible par le client et joue le rôle d'intermédiaire.

Le fonctionnement du système tel que décrit précédemment et en particulier du circuit de reconnexion présente les inconvénients ci-après :

- le fonctionnement du système précité est conditionné par le bon dimensionnement de la résistance R du circuit de reconnexion. En particulier, l'impédance de l'installation domestique du logement varie d'un abonné client à l'autre et au cours du temps pour un client ; et,
- l'intensité i' doit être suffisamment élevée pour être détectée par les systèmes de détection de courants du compteur. Toutefois plus l'intensité i' précitée est élevée et plus les pertes techniques augmentent. Il est donc nécessaire à la fois d'identifier la plage de l'impédance de l'installation domestique du logement et la valeur minimale admissible pour ce courant i'. Un courant i' supérieur à 10 milliampères apparaît a priori nécessaire ;
- les pertes techniques sont celles engendrées entre l'instant où l'organe de coupures s'ouvre et celui où le client abonné ouvre son disjoncteur interne, un faible courant étant engendré par le compteur vers l'intérieur de l'habitat. Les pertes techniques précitées sont estimées à environ 2W.

En outre, même dans le cas où l'abonné client n'est pas autorisé à refermer son organe de coupure par l'intermédiaire de son disjoncteur interne, lorsque par exemple cet abonné client est débiteur d'impayés, le courant précité est tout de même engendré en raison de l'architecture électrique du circuit de reconnexion.

En définitive, quelle qu'en soit la raison, il se peut, dans certains cas, que l'organe de coupure d'un compteur reste ouvert alors que le disjoncteur est maintenu fermé. Dans une telle situation, le faible courant engendré en permanence provoque des pertes techniques d'énergie électrique, lesquelles peuvent devenir d'autant plus importantes que la coupure est longue.

A titre d'exemple non limitatif, sur le territoire français, comportant 50 % des clients dont le compteur est inaccessible et pour environ 1 % de ces clients dont le contrat est suspendu sur une année, il existe environ 170 000 compteurs consommant en permanence 2W, soit une perte d'énergie électrique de 3GWh par an.

Le document JP 11 273538 A divulgue un compteur selon le préambule de la revendication 1.

La présente invention à pour objet de remédier aux inconvénients précités.

En particulier, un objet de la présente invention est la mise en oeuvre d'un compteur électronique d'énergie électrique d'une installation d'abonné à refermeture commandée de l'organe de coupure par l'intermédiaire d'un disjoncteur d'abonné présentant la totalité des fonctionnalités des compteurs de l'art antérieur, mais dans lequel les inconvénients de l'existence d'un courant de réseau abonné de refermeture sont sensiblement supprimés.

En pariculier, un autre objet de la présente invention est la mise en oeuvre d'un compteur électronique d'énergie électrique d'une installation d'abonné à refermeture de l'organe de coupure par l'intermédiaire d'un disjoncteur d'abonné, dans lequel une isolation galvanique totale de la phase est introduite lors de la détection de l'ouverture/fermeture du disjoncteur d'abonné, en l'absence totale de courant de réseau abonné de refermeture à 50Hz pour l'exécution de la détection précitée.

Le compteur électronique d'énergie électrique objet de la présente invention, est defini par la revendication 1.

Le compteur électronique d'énergie électrique, objet de l'invention, est en outre remarquable en ce que le circuit générateur comporte au moins

- un oscillateur HF délivrant une tension HF à l'enroulement primaire d'un transformateur d'isolement et un circuit de connexion HF formé par l'enroulement secondaire du transformateur d'isolement. Cet enroulement secondaire étant relié par une première capacité de liaison, d'une part, au contact ouvert de l'organe de coupure, et, d'autre part, par une deuxième capacité de liaison à un circuit résistif de détection du courant HF reliant la deuxième capacité de liaison au neutre.

Le compteur électronique objet de l'invention est en outre remarquable en ce que le circuit de commande à la fermeture comporte au moins un circuit de mesure de la tension HF et de l'intensité du courant HF aux bornes de respectivement circulant dans le circuit résistif de détection de ce courant HF et un circuit logique de commande à la fermeture de l'organe de coupure, conditionnellement à la valeur de l'intensité du courant HF mesurée.

Le compteur électronique objet de l'invention est enfin remarquable en ce que, pour un compteur électronique comportant une ressource de transmission de données numériques par courants porteurs en ligne, l'oscillateur HF est constitué par l'oscillateur délivrant le signal porteur HF des courants porteurs en ligne.

Le compteur électronique d'énergie électrique à refermeture commandée de l'organe de coupure par l'intermédiaire d'un disjoncteur d'abonné, objet de l'invention, sera mieux compris à la lecture de la description et à l'observation des dessins ci-après dans lesquels, outre les figures 1a et 1b relatives à l'art antérieur.

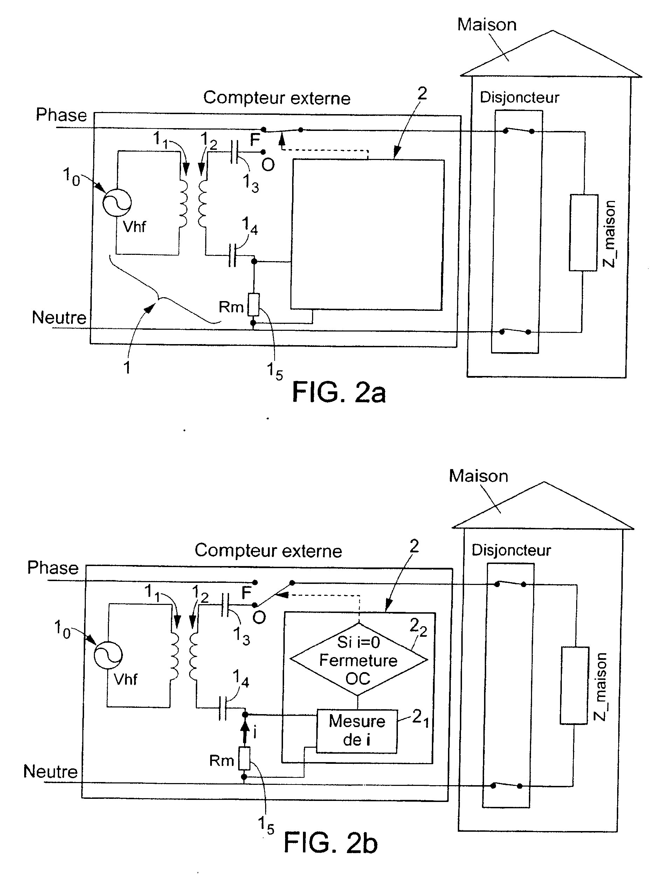

La figure 2a représente, à titre purement illustratif, un agencement de compteur électronique conforme à l'objet de la présente invention ;

La figure 2b représente, à titre purement illustratif, un détail de mise en oeuvre de l'agencement de compteur électronique objet de l'invention représenté en figure 2a ;

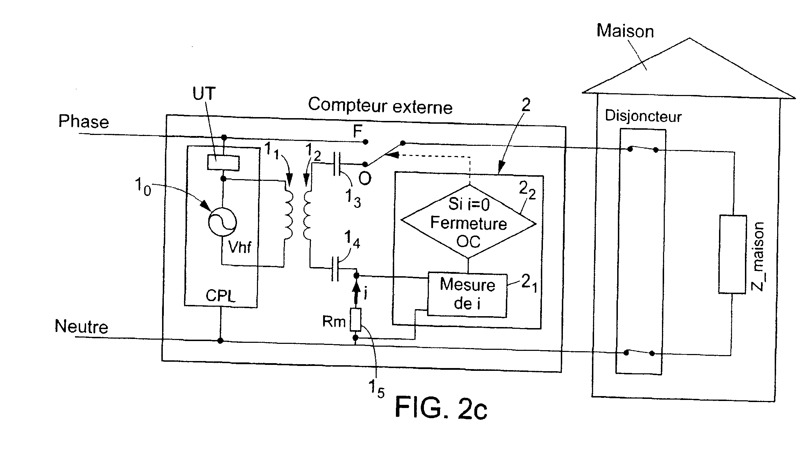

La figure 2c représente une variante de mise en oeuvre préférentielle du compteur électronique objet de l'invention, dans le cas d'un compteur électronique équipé de ressources de transmission de données par courants porteurs en ligne.

Une description plus détaillée du compteur électronique d'énergie électrique d'une installation d'abonné à refermeture commandée de l'organe de coupure par l'intermédiaire d'un disjoncteur d'abonné, conforme à l'objet de la présente invention, sera maintenant donnée en liaison avec la figure 2a et les figures suivantes.

Ainsi qu'on l'a représenté sur la figure 2a, le compteur précité est un compteur externe à une maison d'habitation.

L'installation de l'abonné dans la maison d'habitation comprend, de manière classique, un disjoncteur, à commande automatique et manuelle, et l'ensemble des installations domestiques dont l'impédance équivalente est notée Z_maison.

Le compteur électronique d'énergie électrique objet de l'invention comprend, outre les circuits traditionnels de comptage d'énergie électrique et de transmission-réception de données numériques nécessaires à la gestion du compteur et de l'ensemble des fonctions de ce dernier, ces circuits n'étant pas représentés au dessin afin de ne pas surcharger l'ensemble, un circuit 1 générateur d'un courant HF vers l'installation d'abonné par l'intermédiaire de l'organe de coupure, noté OC, lorsque ce dernier est en position d'ouverture, notée O, et du disjoncteur d'abonné lorsque ce dernier est en position de fermeture. On comprend, en particulier, qu'au contraire lorsque l'organe de coupure OC est en position de fermeture F, l'installation de l'abonné est alimentée en énergie électrique par l'intermédiaire du disjoncteur.

Ainsi qu'on l'a représenté en outre en figure 2a, le compteur électronique objet de l'invention comprend un circuit de commande 2 exécutant une commande à la fermeture de l'organe de coupure OC, conditionnellement à la détection de l'annulation du courant HF, sur ouverture du disjoncteur d'abonné par l'abonné client.

Ainsi qu'on l'a en outre représenté de manière plus détaillée en figure 2a, le circuit générateur 1 comporte au moins un oscillateur HF $1_0$ lequel délivre une tension HF à l'enroulement primaire $1_1$ d'un transformateur d'isolement T.

Le circuit générateur 1 comporte en outre un circuit de connexion HF formé par l'enroulement secondaire $1_2$ du transformateur d'isolement T. Cet enroulement secondaire est relié par une première capacité de liaison $1_3$ au contact ouvert O de l'organe de coupure OC. L'enroulement secondaire $1_2$ précité est en outre relié à un circuit résistif $1_5$ de détection du courant HF par une deuxième capacité de liaison $1_4$, le circuit résistif $1_5$ étant relié au neutre.

En outre, le circuit résistif $1_5$ est connecté au circuit de commande 2 à la fermeture de l'organe de coupure pour déclenchement de la commande à la fermeture précitée.

Ainsi qu'on l'a représenté de manière plus détaillée en figure 2b, le circuit de commande 2 à la fermeture comporte avantageusement un circuit $2_1$ de mesure de la tension HF et de l'intensité du courant HF aux bornes et circulant dans le circuit résistif $1_5$ de détection de ce courant HF. Le circuit de mesure précité est connecté à un circuit logique de commande à la fermeture $2_2$ de l'organe de coupure OC conditionnellement à la valeur de l'intensité du courant HF mesuré dans le circuit résistif $1_5$.

À titre d'exemple non limitatif, le circuit de mesure $2_1$ peut être formé par un circuit d'échantillonnage accompagné d'un convertisseur analogique-numérique, lequel délivre des valeurs numériques représentatives de la valeur de l'intensité du courant HF circulant dans le circuit résistif $1_5$.

En ce qui concerne le circuit logique de commande $2_2$, on indique que celui-ci est un circuit comparateur comparant la valeur de l'intensité mesurée du courant HF à la valeur zéro.

Si la valeur d'intensité i = 0 est détectée, l'abonné l'utilisateur du disjoncteur ayant manipulé manuellement le disjoncteur à l'ouverture, l'organe de coupure OC en position d'ouverture O est alors commandé à la fermeture, position F, par l'intermédiaire du circuit logique de commande à la fermeture $2_2$. Dans ces conditions, l'alimentation en énergie électrique de l'installation de l'abonné peut alors être effectuée par l'intermédiaire du disjoncteur, repassé en position de fermeture.

D'une manière plus spécifique, on indique que le circuit logique de commande $2_2$ est avantageusement couplé à un organe électromécanique actionneur de l'organe de coupure OC pour amener ce dernier en position de fermeture F.

Une variante de mise en oeuvre du compteur électronique objet de l'invention est maintenant décrite en liaison avec la figure 2c.

Cette variante de mise en oeuvre concerne les compteurs électroniques d'énergie électrique munis de ressources de transmission-réception de données numériques par courant porteur en ligne, communément désignés CPL.

Dans cette situation, le compteur objet de l'invention est muni de l'unité de courants porteurs en ligne, notée CPL sur la figure 2c, laquelle bien entendu est équipée d'un oscillateur HF délivrant un signal porteur d'une fréquence comprise entre 3kHz et 148,5 kHz. Cette unité CPL est équipée d'une unité de traitement du signal porteur UT, afin de transmettre les données numériques sur la ligne de phase et le neutre de manière classique.

Toutefois, selon un aspect remarquable du compteur électronique objet de l'invention, l'oscillateur HF tel que décrit en figure 2a ou 2b, est constitué par l'oscillateur délivrant le signal porteur HF des courants porteurs en ligne.

On comprend bien sûr que, dans le mode de réalisation préférentiel non limitatif de la figure 2c, le compteur électronique objet de l'invention permet une mise en oeuvre simplifiée utilisant des ressources existantes de compteur de type classique.

D'une manière générale, on indique que le compteur électronique objet de l'invention est un compteur monophasé, triphasé ou multiphasé. Dans le cas d'un compteur tri- ou multiphasé, les circuits représentés en figures 2a, 2b et 2c peuvent être répliqués pour plusieurs phases.

Alors que le compteur électronique objet de l'invention met en oeuvre l'ensemble des fonctions des dispositifs de l'art antérieur tels que décrits précédemment dans la description, on indique que ce dernier permet en outre d'optimiser deux aspects majeurs :

- la consommation électrique ;
- l'isolation de la ou des phase(s) du compteur.

En particulier, les avantages ci-après sont obtenus grâce à la mise en oeuvre du compteur électronique objet de l'invention :

- l'émission du courant haute fréquence ne se fait pas au détriment de l'isolation diélectrique de l'organe de coupure OC, contrairement à la solution de l'art antérieur, laquelle introduit un circuit qui peut potentiellement court-circuiter l'organe de coupures ouvert ;
- l'isolation galvanique de la ou des phase(s) permet de supprimer l'émission de courants à 50 Hz qui transitent pour la détection de l'ouverture/fermeture du disjoncteur dans la solution de l'art antérieur. Cette particularité permet de préserver une véritable isolation galvanique lorsque l'organe du de coupure OC du compteur est ouvert;
- cette solution permet de réduire les consommations électriques dues à l'émission du signal de détection d'un facteur 1000 environ. En effet, la puissance d'émission maximale admise sur la bande A CENELEC (bande de fréquences comprises entre 9 kHz et 95 kHz) est de 134dB $\mu$V ce qui correspond sur un réseau d'impédance 50 ohms à une puissance de 2 mW. Cette valeur est à comparer à la consommation estimée du système de reconnexion de l'art antérieur décrit dans l'introduction la description, laquelle est de l'ordre de 2 W;
- adopter une stratégie optimale d'émissions permet en outre de réduire ces consommations. En effet, l'émission du signal haute fréquence peut n'avoir lieu que sur certaines fenêtres temporelles, à une fréquence donnée, réduisant ainsi la consommation électrique ;
- émettre le signal de détection uniquement lorsque cela s'avère nécessaire, en fonction du paramétrage du compteur, permet aussi d'optimiser les consommations électriques. Par exemple, lorsque le compteur n'a pas l'autorisation d'ordre de fermeture de l'organe de coupure OC en local, lors par exemple de l'absence d'autorisation pour cause d'impayés;
- mutualisation des circuits du compteur. Il est ici important de rappeler que les compteurs du futur sont équipés de ressources d'émission soit de transmission-réception de données numériques par courants porteurs en ligne et il est particulièrement avantageux d'utiliser le générateur du signal porteur de ces derniers dans le but de mettre en oeuvre l'objet de la présente invention.

## Revendications

**1.** Compteur électronique d'énergie électrique comprenant un organe de coupure à refermeture commandée par l'intermédiaire d'un disjoncteur d'un abonné, **caractérisé en ce qu'**il comporte, sur au moins une phase :

  - un circuit générateur (1) arrangé pour fournir un courant HF au disjoncteur d'abonné par l'intermédiaire de l'organe de coupure lorsque ledit organe de coupure est en position d'ouverture ;
  - un circuit de commande à la fermeture de l'organe de coupure, conditionnellement à la détection de l'annulation dudit courant HF engendrée par l'ouverture dudit disjoncteur par l'abonné.

**2.** Compteur selon la revendication 1, **caractérisé en ce que** ledit circuit générateur comporte au moins :

  - un oscillateur HF délivrant une tension HF à l'enroulement primaire d'un transformateur d'isolement ;
  - un circuit de connexion HF formé par l'enroulement secondaire dudit transformateur d'isolement, ledit enroulement secondaire étant relié d'une part, par une première capacité de liaison, au contact ouvert dudit organe de coupure, et, d'autre part, par une deuxième capacité de liaison à un circuit résistif de détection dudit courant HF reliant ladite deuxième capacité de liaison au neutre.

**3.** Compteur selon la revendication 1 ou 2, **caractérisé en ce que** ledit circuit de commande à la fermeture comporte au moins :

  - un circuit de mesure de la tension HF et de l'intensité du courant HF aux bornes de respectivement circulant dans ledit circuit résistif de détection de ce courant HF ;
  - un circuit logique de commande à la fermeture de l'organe de coupure, conditionnellement à la valeur de l'intensité du courant HF mesurée.

4. Compteur selon la revendication 3, **caractérisé en ce que** ledit circuit logique est couplé à un organe électromécanique actionneur dudit organe de coupure.

5. Compteur selon l'une des revendications 2 à 4, **caractérisé en ce que**, pour un compteur électronique comportant une ressource de transmission de données numériques par courants porteurs en ligne, ledit oscillateur HF est constitué par l'oscillateur délivrant le signal porteur HF des courants porteurs en ligne.

**Patentansprüche**

1. Elektronischer Elektrizitätszähler umfassend ein Abschaltorgan zur Schließung, die mittels eines Schutzschalters eines Abnehmers gesteuert wird, **dadurch gekennzeichnet, dass** er für mindestens eine Phase umfasst:

   - einen Generatorschaltkreis (1), der angeordnet ist, um dem Schutzschalter des Abnehmers mittels des Abschaltorgans einen Hochfrequenzstrom zu liefern, wenn das Abschaltorgan in Offenstellung ist;
   - einen Steuerschaltkreis zur Schließung des Abschaltorgans, sofern ein Ausfall des Hochfrequenzstromes detektiert wird, der durch die Öffnung des Schutzschalters des Abnehmers hervorgerufen wird.

2. Zähler nach Anspruch 1, **dadurch gekennzeichnet, dass** der Generatorschaltkreis mindestens umfasst:

   - einen Hochfrequenzoszillator, der der Primärspule eines Isoliertransformators eine Hochfrequenzspannung liefert;
   - einen Hochfrequenzverbindungsschaltkreis, der durch die zweite Spule des Isoliertransformators gebildet wird, wobei die zweite Spule einerseits durch eine erste Verbindungskapazität mit dem offenen Kontakt des Abschaltorgans verbunden ist und andererseits durch eine zweite Verbindungskapazität mit einem Widerstandsschaltkreis zur Detektion des Hochfrequenzstromes verbunden ist, der die zweite Verbindungskapazität mit der Erde verbindet.

3. Zähler nach Anspruch 1 oder 2, **dadurch gekennzeichnet, dass** der Steuerschaltkreis zur Schließung mindestens umfasst:

   - einen Schaltkreis zur Messung an den Anschlüssen der Hochfrequenzspannung und der Intensität des Hochfrequenzstromes, die jeweils in dem Widerstandsschaltkreis zur Detektion des Hochfrequenzstromes sind;
   - einen Logikschaltkreis zur Steuerung der Schließung des Abschaltorgans in Abhängigkeit von dem Wert der gemessenen Intensität des Hochfrequenzstromes.

4. Zähler nach Anspruch 3, **dadurch gekennzeichnet, dass** der Logikschaltkreis an ein elektromechanisches Betätigungsorgan des Abschaltorgans gekoppelt ist.

5. Zähler nach einem der Ansprüche 2 bis 4, **dadurch gekennzeichnet, dass** für einen elektronischen Zähler, der ein Mittel zur Übertragung von numerischen Daten mittels einer Trägerfrequenzanlage aufweist, der Hochfrequenzoszillator durch den Oszillator gebildet wird, der das Hochfrequenzträgersignal der Trägerfrequenzanlage liefert.

**Claims**

1. Electronic meter for electric power comprising a cut-off member having a controlled reclosing via a circuit breaker of a subscriber, **characterized in that** it comprises, on at least one phase:

   - a circuit generating (1) adapted to provide an HF current to the circuit breaker of a subscriber via the cut-off member when the cut-off member is in open;
   - a circuit for controlling the closing of the cut-off member, upon a detection of the HF current cancellation caused by the opening of said circuit breaker by the subscriber.

2. Meter according to claim 1, **characterized in that** said generating circuit comprises at least:

   - an HF oscillator delivering an HF voltage to the primary winding of an isolating transformer;
   - an HF connection circuit formed by the secondary winding of said isolating transformer, said secondary winding being linked on the one hand, by a first coupling capacitor, to the open contact of said cut-off member, and, on the other hand, by a second coupling capacitor to a resistance circuit for the detection of said HF current linking said second coupling capacitor to neutral.

3. Meter according to claim 1 or 2, **characterized in that** said circuit for controlling the closing comprises at least:

   - a circuit for the measurement of the HF voltage and the intensity of the HF current at the terminals of and respectively flowing in said resistance circuit for detection of this HF current;
- a logic circuit for controlling the closing of the cut-off member according to the intensity value of the measured HF current.

4. Meter according to claim 3, **characterized in that** said logic circuit is coupled to an electromechanical actuator of said cut-off member.

5. Meter according to one of the claims 2 to 4, **characterized in that**, for an electronic meter comprising a resource for the transmission of digital data by power-line carrier currents, said HF oscillator is constituted by the oscillator delivering the HF carrier signal of the power-line carrier currents.

# FIG. 1a
## (ART ANTÉRIEUR)

# FIG. 1b
## (ART ANTÉRIEUR)

Maison

Compteur externe

2

Phase

Disjoncteur

$1_1$ $1_2$ F

$1_0$

$1_3$

Vhf

$1_4$

Z_maison

Neutre

Rm

1 $1_5$

## FIG. 2a

Maison

Compteur externe

2

Phase

Disjoncteur

$1_1$ $1_2$ F

$1_0$

$1_3$

Vhf

$2_2$

Si i=0
Fermeture
OC

$1_4$

Z_maison

Mesure
de i

$2_1$

i

Neutre

Rm

$1_5$ FIG. 2b

FIG. 2c

Phase

UT

Compteur externe

Maison

Disjoncteur

2

$1_0$

$1_1$

$1_2$

F

O

Vhf

$1_3$

CPL

$1_4$

Si i=0
Fermeture
OC

$2_2$

Mesure
de i

$2_1$

Neutre

Rm

i

$1_5$

Z_maison

EP 2 304 760 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- ES 2063699

- JP 11273538 A